# EUROPÄISCHE PATENTSCHRIFT

(11) **EP 2 646 178 B1**
(45) Veröffentlichungstag und Bekanntmachung des Hinweises auf die Patenterteilung: **12.01.2022**
(21) Anmeldenummer: 11788436.1
(22) Anmeldetag: 24.11.2011
(51) Int. Cl.: B08B 7/00, C23C 16/44

(54) **REINIGEN VON METALLISCHEN OBERFLÄCHEN IN VAKUUMAPPARATUREN MITTELS LASER**
CLEANING OF METALLIC SURFACES IN VACUUM APPARATUSES USING LASER
NETTOYAGE AU LASER DE SURFACES MÉTALLIQUES DANS DES APPAREILS À VIDE

(30) Priorität: 29.11.2010 DE 102010062082
(43) Veröffentlichungstag der Anmeldung: 09.10.2013
(73) Patentinhaber: Forschungszentrum Jülich GmbH, 52425 Jülich (DE); 4JET Technologies GmbH, 52477 Alsdorf (DE)
(72) Erfinder: LAMBERTZ, Andreas, 52428 Jülich (DE); BERGFELD, Stefan, 52062 Aachen (DE)
(74) Vertreter: Gille Hrabal Partnerschaftsgesellschaft mbB Patentanwälte
(86) Internationale Anmeldenummer: PCT/EP2011/070891
(87) Internationale Veröffentlichungsnummer: WO 2012/072475

(56) Entgegenhaltungen:
- WO-A1-2004/091842
- DE-A1-102006 046 116
- US-A1- 2002 189 636
- US-A1- 2004 096 593
- US-A1- 2009 084 399
- US-A1- 2010 038 825
- US-A1- 2010 192 973

## Beschreibung

Die Erfindung betrifft ein Verfahren und eine Vorrichtung für ein Reinigen einer vorzugsweise metallischen Oberfläche in einer Vakuumkammer einer Beschichtungsanlage und einer chemischen Gasphasenabscheidungsanlage.

Eine chemische Gasphasenabscheidung (CVD) ist ein Beschichtungsverfahren, bei dem an einer Oberfläche eines Substrates aufgrund einer chemischen Reaktion aus der Gasphase eine Feststoffkomponente abgeschieden wird, Die Beschichtung findet grundsätzlich in der Vakuumkammer der Beschichtungsanlage statt. Eine chemische Gasphasenabscheidung wird unter anderem bei der Herstellung von mikroelektronischen Bauelementen eingesetzt wird. Wird eine chemische Gasphasenabscheidung durchgeführt, so wird nicht lediglich ein Substrat in gewünschter Weise beschichtet, sondern auch andere Innenbereiche der Vakuumkammer der Beschichtungsanlage.

Wird zum Beispiel ein Substrat in einer PECVD-Beschichtungsanlage bzw. PECVD-Depositionsanlage mit Silizium plasmaunterstützt beschichtet, um zum Beispiel für eine Solarzelle eine amorphe oder mikrokristalline Siliziumschicht herzustellen, so werden weitere Bereiche ebenfalls mit Silizium beschichtet wie zum Beispiel eine Elektrode, die innerhalb der PECVD-Beschichtungsanlage angeordnet ist, Von einer solchen unerwünschten Beschichtung ist insbesondere die nicht durch ein Substrat abgeschirmte Gegenelektrode betroffen, Diese Gegenelektrode liegt dem zu beschichtenden Substrat gegenüber,

Die vorliegende Erfindung bezieht sich insbesondere auf die Reinigung einer solchen, mit Silizium unerwünscht beschichteten Elektrode einer PECVD-Beschichtungsanlage bzw. PECVD-Depositionsanlage, also einer Anlage in der eine Plasma unterstützte Gasphasenabscheidung durchgeführt wird,

Es ist bekannt, eine mit Silizium beschichtete Elektrode mit Hilfe eines Plasmas zu reinigen oder nach dem Öffnen der Vakuumanlage durch Ätzen oder Abkratzen.

Aus der Druckschrift DE 198 26 160 A1 geht ein Verfahren und eine Vorrichtung zur Reinigung metallischer Körper In einem Plasma hervor. Die zu reinigenden metallischen Körper werden in eine Vakuumkammer gebracht,

In der Vakuumkammer wird eine Inertgasatmosphäre mit einem Inertgasdruck von weniger als 10 Pa erzeugt. In der Vakuumkammer wird ein die zu reinigenden Körper ganz oder weitgehend umschließendes Plasma gezündet. Ein negatives elektrisches Potential wird an den zu reinigenden Körpern gegenüber dem Plasmapotential angelegt. Die durch das Potential zu den zu reinigenden Körpern hin beschleunigten Inertgasionen entfernen die Verunreinigungen durch Abtragen der Oberfläche des Körpers,

Aus der Druckschrift WO 8001363 A1 ist ein Reinigungsverfahren einer CVD-Beschichtungsanlage mittels Plasma bekannt.

Durch sämtliche vorgenannten Verfahren werden die Oberflächen verändert. Reinigen durch Ätzen dauert relativ lang und es müssen schädigende Gase verwendet werden. Muss eine Vakuumkammer zwecks Reinigen geöffnet werden, so muss anschließend relativ lange wieder evakuiert werden. Diese Zeiten reduzieren die Betriebsstunden und die Produktionskapazität,

Die Druckschrift US 2002/0189636A1 offenbart ein Verfahren zur Reinigung einer Prozesskammer, Es wird ein Laser eingesetzt und es entsteht ein Plasma, Der Laser sowie ein Spiegel zur Umlenkung und Fokussierung des Laserlichts befinden sich außerhalb der Prozesskammer, Durch ein Fenster der Prozesskammer hindurch wird Laserlicht in diese Kammer zwecks Reinigung eingeleitet,

Die Druckschrift US 2010/0038825A1 offenbart ein Verfahren zur Herstellung eines Kanals auf der Oberfläche eines Substrats mithilfe von Laserlicht,

Die Druckschrift US 2004/0096593A1 offenbart ein Verfahren zur Präparation eines porösen Films. Mithilfe von ultraviolettem Licht wird in einem Film befindliches Material zur Erzeugung von Poren entfernt. Als Lichtquelle kann ein Laser dienen, dessen Strahl mithilfe einer Optik fokussiert werden kann. Die Optik kann einen Spiegel umfassen.

Es ist Aufgabe der Erfindung, ein verbessertes Reinigungsverfahren bereitzustellen,

Die Aufgabe wird mit dem Verfahren mit den Merkmalen des Anspruchs 1, sowie mit der Beschichtungsanlage mit den Merkmalen des Anspruchs 10. gelöst.

Zur Lösung der Aufgabe wird gemäß Anspruch 1 eine metallische Oberfläche einer Elektrode in einer

Vakuumkammer einer Beschichtungsanlage mit Hilfe eines Lasers gereinigt, Einerseits gelingt es so, die gewünschte Oberfläche zu reinigen, ohne dafür die Vakuumkammer der Beschichtungsanlage öffnen zu müssen. Andererseits ist es so grundsätzlich möglich zu reinigen, ohne die zu reinigende Oberfläche zu verändern. Im Vergleich zu einer Reinigung mit Hilfe von Plasma werden die im Anschluss an das Reinigen hergestellten Halbleiter durch Reste der für die Plasmareinigung eingesetzten Gase nicht kontaminiert. Es wurde festgestellt, dass im Fall der Herstellung von Solarzellen höhere Wirkungsgrade erzielt werden, wenn eine Reinigung mit einem Laser durchgeführt wird und nicht mit Hilfe eines Plasmas, Eine Reinigung mit Hilfe eines Lasers erfordert keinen Einsatz von toxischen, klimaschädlichen oder Material schädigenden Gasen. Eine Reinigung mit Laser kann außerdem besonders schnell durchgeführt werden. Dies gilt vor allem für den Fall von relativ dicken Schichten, die für eine Reinigung entfernt werden müssen.

Das Verfahren wird insbesondere in einer PECVD-Beschichtungsanlage durchgeführt und zwar vor allem in einer Anlage, in der Halbleiterbeschichtungen, insbesondere Siliziumbeschichtungen beispielsweise für die Herstellung von Solarzellen durchgeführt werden. Es scheidet sich bei derartigen Plasma unterstützten CVD-Beschichtungen der Halbleiter bzw. das Silizium auch an der für ein Beschichten eingesetzten Gegenelektrode ab. Mit Hilfe von Laserlicht kann eine solche Halbmetall- bzw. Siliziumschicht von der (Gegen-)Elektrode zwecks Reinigung wieder gelöst werden, ohne die Oberfläche der Elektrode zu beschädigen. Dies gilt insbesondere für den Fall, dass die zu reinigende Elektrode eine metallische Oberfläche aufweist, die Wellenlänge des Lasers zwischen 9 *µ*m und 11 *µ*m liegt und/ oder ein gepulster Laserstrahl eingesetzt wird. Beispielsweise ein CO₂-TEA-Laser, also ein CO₂- Transversal Excited Atmospheric-Pressure-Laser erfüllt die vorgenannten Anforderungen und ist für die Durchführung des Verfahrens gerade im Fall einer unerwünschten Halbmetall- bzw. Siliziumbeschichtung besonders gut geeignet. Ein CO₂-TEA-Laser strahlt mit einer Wellenlänge von 9,3 *µ*m oder 10,6 *µ*m ab. Bei dieser Wellenlänge reflektiert nahezu jedes Metall hervorragend. Folglich dringt ein solcher Laserstrahl kaum in eine Metalloberfläche ein und kann daher diese auch nicht beschädigen. Auf der anderen Seite absorbiert ein Halbmetall wie Silizium bei dieser Wellenlänge noch hinreichend gut, so dass es bei Bestrahlung mit Laserlicht von der Metalloberfläche abplatzt. Zugleich arbeitet der CO₂-TEA-Laser gepulst. Die Pulsdauer von unter 5 *µ*s hat sich als kurz genug herausgestellt, um den gewünschten Abplatzeffekt Im Fall eines Halbmetalls wie Silizium zuverlässig zu erzielen, Es hat sich gezeigt, dass bei einem nicht gepulsten Laser das Problem auftreten kann, dass ein Halbmetall wie Silizium nicht abplatzt, sondern nur umgewandelt wird. Allgemein wird also die Wellenlänge des Laserlichts so ausgesucht, dass das Laserlicht zwar in die Schicht einzudringen vermag, die entfernt werden soll, nicht aber bzw. kaum in die Schichtoberfläche, die gereinigt werden soll. Droht eine Umwandlung des Materials der unerwünschten Schicht, so kann dies durch hinreichend kurze Pulse von in der Regel weniger als 20 *µ*s, bevorzugt von weniger 5 *µ*s vermieden werden. Es hat sich herausgestellt, dass insbesondere durch Abplatzen erreicht wird, dass die insbesondere metallische, zu reinigende Oberfläche nicht beschädigt wird.

Durch geeignete Ausrichtung der zu reinigenden metallischen Oberfläche kann abgeplatztes Schichtmaterial aufgrund von Schwerkraft nach unten fallen und wird so von der zu reinigenden Oberfläche entfernt,

Durch Reinigen bzw. Schwerkraft von einer zu reinigenden Oberfläche entfernte Partikel werden in einer Ausführungsform durch ein Auffangsubstrat, eine Auffangrinne oder einen beispielsweise verschließbaren Auffangbehälter aufgefangen, Auffangsubstrat, Auffangrinne oder Auffangbehälter können aus der Vakuumkammer bei Bedarf beispielsweise über eine Schleuse heraus transportiert und entleert werden. Alternativ kann Auffangsubstrat, Auffangrinne oder Auffangbehälter entleert werden, sobald eine Vakuumkammer auch aus anderen Gründen geöffnet wird.

Im erfindungsgemäßen Verfahren wird vorzugsweise mit Hilfe eines Spiegels, insbesondere eines bewegbaren Spiegels Laserlicht auf die zu reinigende Oberfläche gelenkt. Laserlicht kann bei dieser Ausführungsform beispielsweise von außen über ein Fenster in die Vakuumkammer eingespeist werden. Im Inneren der Vakuumkammer kann das Laserlicht dann durch den Spiegel auf die zu reinigende Oberfläche gelenkt werden. Ist der Spiegel bewegbar, so kann das Laserlicht flexibel auf die jeweils zu reinigende Oberfläche gelenkt werden.

Als Spiegel kann die Oberfläche eines Heizelements, einer Substratablage und/ oder einer Gegenelektrode verwendet werden. Diese Bauteile erfüllen dann eine Doppelfunktion, so dass die Zahl der Teile minimiert wird. Durch Bewegen des Lasers können verschiedene Stellen innerhalb der Vakuumkammer auch dann gereinigt werden, wenn die spiegelnde Oberfläche während des Reinigens nicht oder nicht geeignet bewegt werden kann.

Durch Vielfachreflexionen werden in einer Ausführungsform eine Mehrzahl von Bereichen zeitgleich mit nur einem Laserlicht gereinigt werden. Bei dieser Ausführungsform wird insbesondere ausgenutzt, dass die zu reinigende Oberfläche das Laserlicht zu spiegeln vermag, wodurch Mehrfachreflexionen zwischen dieser spiegelnden Oberfläche und ein oder mehreren weiteren spiegelnden Oberflächen ermöglicht werden.

Eine Depositionsanlage, insbesondere eine PECVD-Depositionsanlage zur Durchführung des Verfahren umfasst einen Laser für ein Reinigen einer Oberfläche, die sich in der Vakuumkammer der Depositionsanlage befindet. Der Laser ist also so angeordnet und ausgelegt, dass mit diesem ein Reinigen einer Oberfläche und zwar insbesondere eine Metalloberfläche einer Gegenelektrode möglich ist. Insbesondere umfasst die Depositionsanlage im Inneren der Vakuumkammer einen vorzugsweise bewegbaren Spiegel, der so angeordnet ist, dass der Laserstrahl auf eine gewünschte, zu reinigende Oberfläche gelenkt werden kann.

Der Laser befindet sich außerhalb der Vakuumkammer. Die Vakuumkammer verfügt über ein Fenster, durch welches ein Laserstrahl des Lasers geeignet in die Vakuumkammer gelangen kann. Der Laser kann ein CO₂-TEA-Laser mit einer Leistung von beispielsweise 200 W sein.

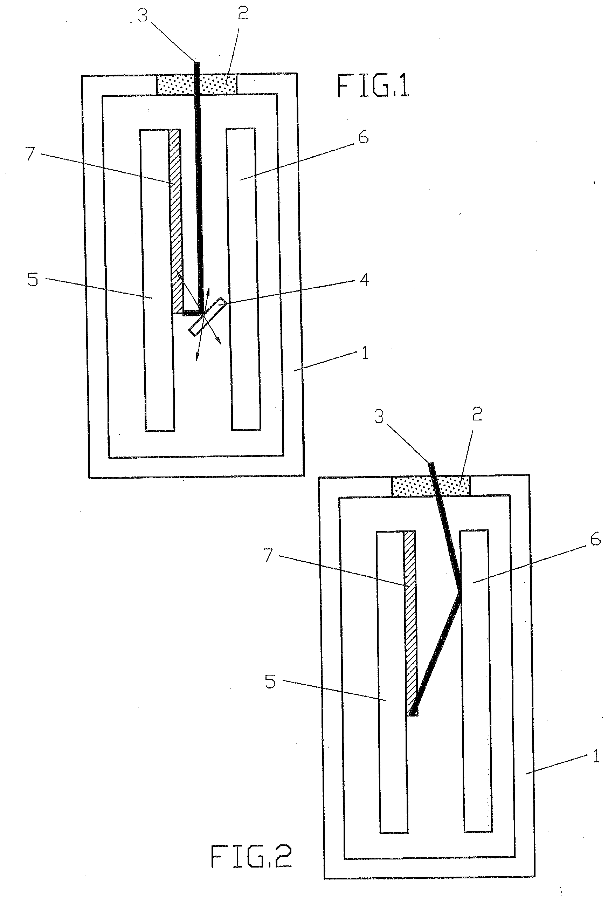

Nachfolgend werden Ausführungsbeispiele der Erfindung näher erläutert. Die Figur 1 zeigt eine Vakuumkammer 1 einer PECVD-Depositionsanlage, in der Beschichtungen durchgeführt werden. Die Vakuumkammer 1 verfügt über ein Fenster 2, über welches ein Laserstrahl 3 eines nicht dargestellten Lasers von oben in die Kammer 1 hinein strahlen kann. Tritt Laserlicht 3 durch das Fenster 2 in die Kammer 1 ein, so trifft der Laserstrahl auf einen bewegbaren Spiegel 4. Der Spiegel 4 lenkt den Laserstrahl 3 in Richtung einer in der Kammer 1 befindlichen, sich vertikal erstreckenden Elektrode 5. Bei der Elektrode 5 handelt es sich um eine Gegenelektrode, die einer beheizbaren, ebenfalls vertikal sich erstreckenden Elektrode 6 gegenüberliegt, Für eine Beschichtung wird an der Elektrode 6 ein zu beschichtendes Substrat angebracht oder angeordnet. Zwecks Beschichtung wird ein Plasma in der Vakuumkammer 1 gezündet. Die anschließend durchgeführte Beschichtung findet nicht nur auf der Oberfläche des Substrates, sondern auch auf der Oberfläche der Gegenelektrode 5 statt. Es entsteht so auf der Gegenelektrode 5 eine Beschichtung 7. Wie grafisch angedeutet, gelingt mit Hilfe des Laserstrahls 3 ein Abplatzen der Schicht 7 und so eine besonders schonende Oberflächenreinigung der metallischen Elektrode 5. Durch entsprechendes Bewegen des Spiegels 4 wird der Laserstrahl 3 über die Oberfläche der Gegenelektrode 5 bewegt und zwar bevorzugt schrittweise, um so die Oberfläche vollständig zu reinigen, Das abgeplatzte Material fällt schwerkraftbedingt nach unten auf den Boden der Kammer 1. Der Boden der Kammer 1 kann einen Auffangbehälter umfassen, der von Zeit zu Zeit geleert wird. Befindet sich kein Auffangbehälter auf dem Boden der Kammer 1, so kann der Boden der Kammer von Zeit zu Zeit ausgekehrt werden.

Die Kammer 1 kann über eine nicht dargestellte Schleuse verfügen, über die ein Auffangbehälter aus der Kammer zu gegebener Zeit zwecks Entleeren herausgenommen wird. Über die Schleuse kann nach einem Entleeren die Auffangkammer wieder in die Vakuumkammer 1 gebracht werden.

In der Figur 2 wird eine Ausführungsform der Erfindung dargestellt, bei der die spiegelnde Oberfläche der metallischen Elektrode 6 als Spiegel verwendet wird, um einen Laserstrahl in Richtung der unerwünschten, in der Regel aus Silizium bestehenden Schicht 7 auf der metallischen Gegenelektrode 5 zu lenken. Durch eine Änderung des Einfallswinkels des Laserstrahls 3 in das Fenster 2 können die verschiedenen, zu reinigenden Oberflächenbereiche der Elektrode 5 vollständig erfasst werden, Der Laserstrahl 3 muss nicht zwingend zunächst auf die beheizbare Elektrode 6 auftreffen, um von hier aus in Richtung Gegenelektrode 5 gespiegelt zu werden. Stattdessen ist es auch möglich, durch Wahl eines entsprechenden Einfallswinkels den Laserstrahl 3 direkt auf die Gegenelektrode 5 bzw. die Schicht 7 zu lenken.

Wiederum sind die beiden Elektroden 5, 6 senkrecht angeordnet, um so zu ermöglichen, dass abgeplatztes Material der Schicht 7 nach unten schwerkraftbedingt zu Boden fällt.

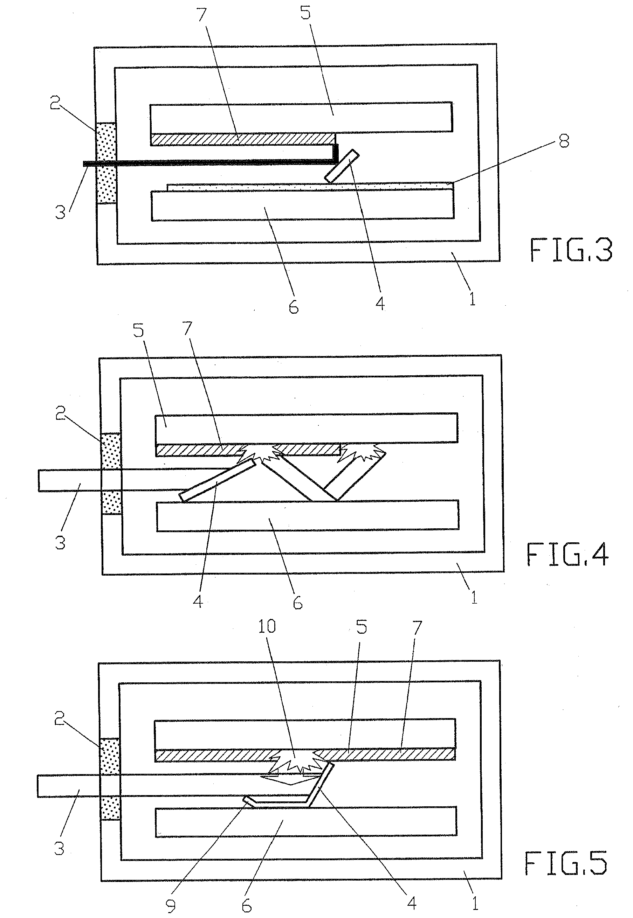

In der Figur 3 wird eine weitere Ausführungsform der Erfindung gezeigt, bei der die Elektroden 5, 6 in Unterschied zu den Ausführungsbeispielen gemäß den Figuren 1 und 2 gegenüberliegend horizontal angeordnet sind. Die Gegenelektrode 5 befindet sich oberhalb der beheizbaren Elektrode 6. Diese Anordnung wird gewählt, damit abgeplatzte Partikel der Schicht 7 auf ein Auffangsubstrat 8 fallen können, welches während einer Reinigung auf der beheizbaren Elektrode 6 aufliegt. Im Anschluss an eine Reinigung kann das Auffangsubstrat 8 über eine Schleuse aus der Kammer herausbewegt werden, um dieses von dem abgeplatzten Schichtmaterial zu reinigen.

Anstelle eines Spiegels 4 kann das Auffangsubstrat spiegelnd ausgestaltet sein, um es so zu ermöglichen, Laserlicht 3 auf die Oberfläche des Auffangsubstrats 8 auftreffen zu lassen. Von hier aus wird das Laserlicht 3 dann in Richtung Schicht 7 bzw. Gegenelektrode 5 gespiegelt.

In der Figur 4 wird eine Ausführungsform der Erfindung gezeigt, bei der mittels Mehrfachreflexionen mehrere Bereiche der Gegenelektrode 5 zeitgleich mit Hilfe eines Laserstrahls 3 gereinigt werden. Sowohl ein Spiegel 4 als auch die Oberfläche der Elektrode 6 dienen der Reflexion von Laserlicht in Richtung spiegelnde Oberfläche der metallischen Gegenelektrode 5. Es wird dabei also ausgenutzt, dass die Oberfläche der Elektrode 5 ebenfalls spiegelnd ausgestaltet ist,

Anstelle eine Spiegels 4 kann auch sofort eine spiegelnde Oberfläche beispielsweise der beheizbaren Elektrode 6 genutzt werden, um so Mehrfachreflexionen zwischen den beiden, gegenüberliegenden Elektroden 5, 6 zu erzeugen.

In der Figur 5 wird eine Ausführungsform gezeigt, bei der der Spiegel 4 direkt mit einem Auffangbehälter 9 verbunden ist oder aber der Spiegel 4 zugleich als Auffangbehälter 9 geformt ist. Vom Spiegel 4, der einen Winkel kleiner als 90° mit der Gegenelektrode 5 einschließt, gelangt Laserlicht 3 auf die Schicht 7. Abplatzendes Material 10 fällt in den sich an den eigentlichen Spiegelbereich 4 anschließenden Bereich 9, der als Auffangbehälter dient. Da in der Vakuumkammer keine Atmosphäre vorhanden ist, wird abgeplatztes Material 10 im Auffangbehälter durch Bewegen des Spiegels 4 nicht derart stark verwirbelt, dass dieses sich unerwünscht aus dem Behälterbereich 9 entfernt,

Eine solche Siliziumschicht 7 konnte mit Hilfe eines CO₂-TEA-Lasers entfernt werden, ohne die Oberfläche einer solchen metallischen Gegenelektrode 5 zu beschädigen, Es wurde mit einer Leistung von ca. 100 W bis 150 W eingestrahlt. Der Laserstrahl wurde schrittweise über die Oberfläche der Gegenelektrode mit einer Geschwindigkeit von 0,3 m/sek bis 0,5 m/sek. bewegt. Der Laserstrahl deckte auf der Oberfläche der Gegenelektrode 5 jeweils einen Bereich von ca. 0,3 cm² bis 0,5 cm² ab. Es konnte in der Regel mit nur einem Arbeitsdurchgang die Siliziumschicht vollständig von der metallischen Oberfläche entfernt werden,

## Patentansprüche

1. Verfahren zum Reinigen einer metallischen Oberfläche in einer Vakuumkammer (1) einer Beschichtungsanlage, insbesondere in einer PECVD-Beschichtungsanlage, wobei innerhalb der Beschichtungsanlage eine Elektroden (6) und eine Gegenelektrode (5) vorhanden sind, sich ein Laser außerhalb der Vakuumkammer befindet und die Vakuumkammer über ein Fenster verfugt, durch welches ein Laserstrahl des Lasers geeignet in die vakuumkammer gelangen kann, wobei die metallische Oberfläche einer Elektrode mittels Laserlicht (3) gereinigt wird, wobei die zu reinigende Oberfläche mit Laserlicht bestrahlt wird.

2. Verfahren nach Anspruch 1, bei dem eine Siliziumschicht (7) von einer Elektrode (5, 6) mittels des Laserlichts (3) entfernt und zwar insbesondere durch Abplatzen entfernt und so gereinigt wird.

3. Verfahren nach Anspruch 1 oder 2, bei dem die Wellenlänge des Laserlichts (3) zwischen 9 *µ*m und 11 *µ*m liegt.

4. Verfahren nach einem der vorhergehenden Ansprüche, **dadurch gekennzeichnet, dass** das Reinigen ein Entfernen einer Siliziumschicht (7) umfasst und zwar insbesondere durch Abplatzen und/ oder mittels Schwerkraft.

5. Verfahren nach einem der vorhergehenden Ansprüche, **dadurch gekennzeichnet, dass** durch Reinigen entfernte Partikel durch ein Auffangsubstrat (8) oder einen Auffangbehälter (9) aufgefangen werden.

6. Verfahren nach einem der vorhergehenden Ansprüche, **dadurch gekennzeichnet, dass** mit Hilfe einer pulsierenden Strahlung (3) eines Pulslasers gereinigt wird.

7. Verfahren nach einem der vorhergehenden Ansprüche, **dadurch gekennzeichnet, dass** mit Hilfe eines eines bewegbaren Spiegels (4) Laserlicht (3) auf die zu reinigende Oberfläche gelenkt wird,

8. Verfahren nach dem vorhergehenden Anspruch, bei dem die Oberfläche eines Heizelements, einer Substratablage oder Elektrode (6) und/ oder einer Gegenelektrode (5) als Spiegel für das Laserlicht (3) verwendet wird.

9. Verfahren nach einem der vorhergehenden Ansprüche, **dadurch gekennzeichnet, dass** durch Vielfachreflexionen eine Mehrzahl von Bereichen zeitgleich gereinigt werden.

10. Depositionsanlage mit einem Laser für ein Reinigen einer metallischen Oberfläche innerhalb der Vakuumkammer (1) der Depositionsanlage, wobei innerhalb der Vakuumkammer eine Elektrode (6) und eine Gegenelektrode (5) vorhanden sind, wobei sich der Laser außerhalb der Vakuumkammer befindet, und die Vakuumkammer über ein Fenster verfügt, durch welches ein Laserstrahl des Lasers geeignet in die Vakuumkammer gelangen kann, wobei einer in der Vakuumkammer befindlichen bewegbaren Spiegel (4) so angeordnet ist, dass eine metallische Oberfläche einer in der Vakuumkammer befindlichen Elektrode (5, 6) durch einen durch den Spiegel gespiegelten Laserstrahl (3) gereinigt werden kann.

11. Depositionsanlage nach Anspruch 10, **dadurch gekennzeichnet, dass** die Depositionsanlage eine PECVD- Depositionsanlage ist, die so eingerichtet ist, dass eine Plasma unterstütze Gasphasenabscheidung durchgeführt werden kann.

12. Depositionsanlage nach Anspruch 10 oder 11, **dadurch gekennzeichnet, dass** der Laser ein CO₂-TEA-Laser ist.

## Claims

1. Method for cleaning a metallic surface in a vacuum chamber (1) of a coating plant, in particular in a PECVD coating plant, wherein an electrode (6) and a counter electrode (5) are present inside the coating plant, a laser is located outside the vacuum chamber and the vacuum chamber has a window through which a laser beam of the laser can suitably pass into the vacuum chamber, wherein the metallic surface of an electrode is cleaned by means of laser light (3), wherein the surface to be cleaned is irradiated with laser light.

2. Method according to claim 1, in which a silicon layer (7) is removed from an electrode (5, 6) by means of the laser light (3), in particular by flaking off, and is thus cleaned.

3. Method according to claim 1 or 2, in which the wavelength of the laser light (3) is between 9 *µm* and 11 *µm.*

4. Method according to one of the preceding claims, **characterized in that** the cleaning comprises a removal of a silicon layer (7), in particular by flaking off and/or by means of gravity.

5. Method according to one of the preceding claims, **characterized in that** particles removed by cleaning are collected by a collection substrate (8) or a collection container (9).

6. Method according to one of the preceding claims, **characterized in that** cleaning is performed using a pulsed radiation (3) of a pulsed laser.

7. Method according to one of the preceding claims, **characterized in that** laser light (3) is directed onto the surface to be cleaned by means of a movable mirror (4).

8. Method according to the preceding claim, in which the surface of a heating element, a substrate deposit or electrode (6) and/or a counter electrode (5) is used as a mirror for the laser light (3).

9. Method according to one of the preceding claims, **characterized in that** a plurality of areas are cleaned simultaneously by multiple reflections.

10. Deposition plant comprising a laser for cleaning a metallic surface within the vacuum chamber (1) of the deposition plant, wherein an electrode (6) and a counter electrode (5) are present inside the vacuum chamber, wherein the laser is located outside the vacuum chamber, and the vacuum chamber has a window through which a laser beam of the laser can suitably pass into the vacuum chamber, wherein a movable mirror (4) located in the vacuum chamber is arranged such that a metallic surface of an electrode (5, 6) located in the vacuum chamber can be cleaned by a laser beam (3) reflected by the mirror.

11. Deposition plant according to claim 10, **characterized in that** the deposition plant is a PECVD deposition plant configured such that a plasma assisted vapor deposition can be performed.

12. Deposition plant according to claim 10 or 11, **characterized in that** the laser is a C0₂ TEA laser.

## Revendications

1. Procédé de nettoyage d'une surface métallique dans une chambre à vide (1) d'un système de revêtement, en particulier système de revêtement PECVD, dans lequel une électrode (6) et une contre-électrode (5) sont présentes dans le système de revêtement et un laser se situe à l'extérieur de la chambre à vide et la chambre à vide comprend une fenêtre à travers laquelle un faisceau laser du laser peut entrer de manière appropriée dans la chambre à vide, dans lequel la surface métallique d'une électrode est nettoyée moyennant lumière laser (3), dans lequel la surface à nettoyer est irradiée avec lumière laser.

2. Procédé selon la revendication 1, dans lequel une couche de silicium (7) est éliminée, en particulier par écaillage, d'une électrode (5, 6) moyennant la lumière laser (3) de sorte qu'elle est nettoyée ainsi.

3. Procédé selon la revendication 1 ou 2, dans lequel la longueur d'onde de la lumière laser (3) est comprise entre 9 µm et 11 µm.

4. Procédé selon l'une quelconque des revendications précédentes, **caractérisé en ce que** le nettoyage comprend l'élimination d'une couche de silicium (7), notamment par écaillage et/ou par gravité.

5. Procédé selon l'une quelconque des revendications précédentes, **caractérisé en ce que** les particules éliminées par nettoyage sont collectées par un substrat collecteur (8) ou un récipient collecteur (9).

6. Procédé selon l'une quelconque des revendications précédentes, **caractérisé en ce que** le nettoyage s'effectue moyennant un rayonnement pulsé (3) d'un laser pulsé.

7. Procédé selon l'une quelconque des revendications précédentes, **caractérisé en ce que** lumière laser (3) est dirigée moyennant un miroir mobile (4) sur la surface à nettoyer.

8. Procédé selon la revendication précédente, dans lequel la surface d'un élément chauffant, d'un porte-substrat ou d'une électrode (6) et/ou d'une contre-électrode (5) sert de miroir pour la lumière laser (3).

9. Procédé selon l'une quelconque des revendications précédentes, **caractérisé en ce que** plusieurs zones sont nettoyées en même temps par réflexions multiples.

10. Système de déposition avec un laser pour nettoyer une surface métallique à l'intérieur de la chambre à vide (1) du système de déposition, dans lequel une électrode (6) et une contre-électrode (5) sont présentes à l'intérieur de la chambre à vide, dans lequel le laser est situé à l'extérieur de la chambre à vide, et la chambre à vide comprend une fenêtre à travers laquelle un faisceau laser du laser peut entrer de manière appropriée dans la chambre à vide, dans lequel un miroir mobile (4) situé dans la chambre à vide est arrangé de sorte qu'une surface métallique d'une électrode (5, 6) située dans la chambre à vide peut être nettoyée par un faisceau laser (3) réfléchi par le miroir.

11. Système de déposition selon la revendication 10, **caractérisé en ce que** le système de déposition est un système de déposition PECVD qui est mis en place de telle manière qu'une déposition de phase gazeuse assistée par plasma peut être effectuée.

12. Système de déposition selon la revendication 10 ou 11, **caractérisé en ce que** le laser est un laser C0₂-TEA.
